# EUROPÄISCHE PATENTSCHRIFT

(11) **EP 2 680 332 B1**
(45) Veröffentlichungstag und Bekanntmachung des Hinweises auf die Patenterteilung: **10.05.2017**
(21) Anmeldenummer: 13173332.1
(22) Anmeldetag: 24.06.2013
(51) Int. Cl.: H01L 35/30, H02N 11/00

(54) **Energieversorgung für einen Verbraucher eines Fahrzeugs**
Power supply for a consumer in a vehicle
Alimentation en énergie pour un consommateur d'un véhicule

(30) Priorität: 25.06.2012 DE 102012105531
(43) Veröffentlichungstag der Anmeldung: 01.01.2014
(73) Patentinhaber: Airbus Defence and Space GmbH, 85521 Ottobrunn (DE)
(72) Erfinder: Elefsiniotis, Alexandros, 81375 München (DE); Weiß, Matthias, 80805 München (DE); Becker, Prof. Dr. Thomas, 27711 Osterholz-Scharmbeck (DE); Schmid, Prof. Dr. Ulrich, 1140 Wien (AT)
(74) Vertreter: Lorenz & Kopf PartG mbB Patentanwälte, LKGLOBAL

(56) Entgegenhaltungen:
- WO-A1-2011/161167
- WO-A1-2012/068218
- DE-A1-102009 038 925
- FR-A1- 2 946 353
- JP-A- 2003 219 671
- A. ELEFSINIOTIS ET AL: "Design and material aspects for thermoelectric energy harvesting devices in aircrafts", PROCEEDINGS OF SPIE, Bd. 8763, 17. Mai 2013 (2013-05-17), Seite 87631N, XP055096638, ISSN: 0277-786X, DOI: 10.1117/12.2017311

## Beschreibung

### Gebiet der Erfindung

Die Erfindung betrifft die Versorgung von elektrischen Verbrauchern in Fahrzeugen mit elektrischer Energie. Insbesondere betrifft die Erfindung eine Energieversorgungseinheit für einen elektrischen Verbraucher eines Fahrzeugs, ein elektrisches System für ein Fahrzeug, eine Verwendung der Energieversorgungseinheit in einem Fahrzeug und ein Luftfahrzeug mit einer Energieversorgungseinheit.

### Hintergrund der Erfindung

Bestimmte elektrische Systeme in Fahrzeugen, und insbesondere in Luftfahrzeugen, können in Bereichen des Fahrzeugs angebracht sein, die nur mit hohem technischen Aufwand mit elektrischen Leitungen zur Stromversorgung des elektrischen Systems ausgestattet werden können. In diesem Fall können die elektrischen Systeme eine autarke Energieversorgungseinheit aufweisen, die lokal in der Nähe des elektrischen Systems angebracht ist. Durch diese lokale Energieversorgung können beispielsweise Sensoren autonom in für Kabel unzugängliche oder nur schwer zugängliche Bereiche am Flugzeug betrieben werden.

Die Energieversorgungseinheit kann dabei als sog. "Energy Harvester" (Energiesammler bzw. Energiewandler) ausgebildet sein, der in der Lage ist, elektrische Energie aus einer lokalen Quelle zu gewinnen. Als "Energy Harvesting" (Energie sammeln) kann die Erzeugung von Strom aus Quellen, wie Umgebungstemperatur, Vibrationen oder Licht, bezeichnet werden. So können beispielsweise Temperaturgradienten oder Vibrationen genutzt werden, durch welche Energie aus Energieverlusten durch den Betrieb des Flugzeugs zurückgewonnen werden kann.

Vibrationsenergie-Harvesting ist für Flugzeuge, insbesondere Starrflügler, häufig ungeeignet, da die Amplituden der Schwingungen relativ klein und die Frequenzen der Schwingungen relativ hoch sind. Auch Solarzellen sind in der Regel aufgrund der wechselnden Lichtbedingungen ebenfalls nicht für die Energieversorgung von autonomen, drahtlosen Flugzeugsystemen geeignet.

DE 10 2008 031 266 A1 beschreibt eine Energieversorgungseinheit (Thermogenerator), welche einen thermoelektrischen Generator aufweist, der mit einem Phasenwechselelement verbunden ist. Die Energieversorgungseinheit ermöglicht die Ausnutzung der sich verändernden Umgebungstemperaturen zur Erzeugung elektrischer Energie.

In der JP 2003 219671 A und der WO 2011/161167 A1 (US 2013/0098417 A1) werden Energieversorgungseinheiten offenbart, bei denen Phasenwechselelemente bezüglich eines Wärmestroms in Reihe geschaltet sind.

### Zusammenfassung der Erfindung

In Fahrzeugen treten oft verhältnismäßig hohe Temperaturunterschiede zwischen dem Fahrzeuginneren und dem Fahrzeugäußeren auf. Des Weiteren treten, speziell bei Luftfahrtzeugen, schnelle Temperaturwechsel bei Start und Landung auf.

Es ist Aufgabe der Erfindung, eine Energieversorgungseinheit bereitzustellen, welche auf einfache und effektive Art und Weise die oben genannten Temperaturunterschiede zur Energiegewinnung nutzen kann.

Diese Aufgabe wird durch den Gegenstand der unabhängigen Ansprüche gelöst. Weitere Ausführungsformen der Erfindung ergeben sich aus den abhängigen Ansprüchen und aus der vorliegenden Beschreibung.

Ein Aspekt der Erfindung betrifft eine Energieversorgungseinheit für einen elektrischen Verbraucher eines Fahrzeugs.

Bei einem solchen Fahrzeug kann es sich beispielsweise um ein Luftfahrzeug, ein Wasserfahrzeug oder ein Landfahrzeug handeln. Insbesondere kann es sich um ein Flugzeug, wie beispielsweise ein Passagierflugzeug, ein Luftschiff, einen Helikopter, ein Schiff, ein U-Boot, ein Schienenfahrzeug oder ein Straßenfahrzeug handeln.

Bei dem elektrischen Verbraucher kann es sich beispielsweise um eine elektrische/elektronische Komponente oder einen Sensor/Aktuator handeln.

Gemäß einer Ausführungsform der Erfindung weist die Energieversorgungseinheit einen ersten thermoelektrischen Generator und einen zweiten thermoelektrischen Generator auf. Jeder dieser thermoelektrischen Generatoren ist an ein oder mehrere Phasenwechselelemente angeschlossen oder zumindest thermisch daran gekoppelt. Beispielsweise ist eine Seite des ersten thermoelektrischen Generators mit einem ersten Phasenwechselelement verbunden, und eine Seite des zweiten thermoelektrischen Generators ist mit einem zweiten Phasenwechselelement verbunden. Bei den Phasenwechselelementen handelt es sich um Wärmespeicherelemente, welche Wärme über einen Phasenwechsel speichern können.

Gemäß einer Ausführungsform der Erfindung weisen die beiden Phasenwechselelemente verschiedene Phasenwechselpunkte auf, an denen ein Übergang von einer Phase des Phasenwechselmaterials in eine andere Phase stattfindet. Beispielsweise weist das erste Phasenwechselelement einen höheren Schmelzpunkt auf als das zweite Phasenwechselelement, oder umgekehrt.

In anderen Worten weist die Energieversorgungseinheit demnach mehrere thermoelektrische Generatoren auf, die an jeweils einer ihrer Seiten mit einem eigenen Phasenwechselelement (welches ein sog. Phasenwechselmatetrial (Phase Change Material, PCM) aufweist) verbunden sind. Da die Phasenwechselmaterialien voneinander unterschiedliche Schmelzpunkte oder Gefrierpunkte aufweisen, an denen ein Übergang von einer Phase in eine zweite Phase stattfindet, können Phasenwechsel bei verschiedenen Temperaturen stattfinden, wodurch die Effektivität der Energieversorgungseinheit erhöht werden kann.

Als Materialien für das Phasenwechselelement kommen beispielsweise Wasser, Selen, Glycol oder Erythritol (C₄H₁₀O₄) in Betracht. Auch ist es möglich, Magnesiumchlorid-Hexahydrat, bestimmte Öle oder Wachse zu verwenden.

Ist die Energieversorgungseinheit in dem Fahrzeug eingebaut, ist die eine Seite eines jeden thermoelektrischen Generators an das entsprechende Phasenwechselelement angeschlossen bzw. steht in thermischen Kontakt damit, wohingegen die zweite Seite eines jeden thermoelektrischen Generators entweder an einem darunter befindlichen Phasenwechselelement (mit einem anderem Phasenwechselpunkt) oder an einem Wärmereservoir (Wärmequelle oder Wärmesenke) angeschlossen ist.

Bei diesem Wärmereservoir kann es sich beispielsweise um die Außenhaut des Fahrzeugs handeln, welche mit der Fahrzeugumgebung in Verbindung steht, so dass die Kälte der Umgebung an die zweite Seite des thermoelektrischen Generators abgegeben werden kann. Aus dem Temperaturgradienten zwischen der Umgebung und dem Phasenwechselelement kann dann elektrische Energie erzeugt werden.

Eine mögliche Anwendung der Energieversorgungseinheit ist demnach die Montage im Bereich der Außenhaut eines Luftfahrzeugs, wobei eine Generatoroberfläche in der Nähe der Umgebungstemperatur des Luftfahrzeugs liegt, während die andere Generatoroberfläche im thermischen Kontakt mit dem entsprechenden Phasenwechselelement steht, welches im Inneren des Luftfahrzeugs angeordnet ist.

Die Erfindung ermöglicht somit während einer Phase sich zeitlich verändernder Umgebungstemperaturen die Erzeugung elektrischer Energie, die während dieser Betriebsphase dazu ausgenutzt werden kann, Verbraucher geringen Energiebedarfs, wie Sensoren, zu betreiben, die ohne externe Zuführungen elektrischen Stroms (z. B. Kabel) montiert werden können. Durch die Anbringung von Energiespeicherelementen, wie Kondensatoren oder Akkumulatoren, ist es auch möglich, einen Teil der nicht benutzten elektrischen Energie zwischenzuspeichern.

Gemäß der Erfindung ist das erste Phasenwechselelement neben dem zweiten Phasenwechselelement angeordnet. Die beiden Phasenwechselelemente sind also bezüglich eines Wärmestroms parallel geschaltet und jeweils mit einem oder mehreren thermoelektrischen Generatoren verbunden.

Ist die Energieversorgungseinheit in dem Fahrzeug eingebaut, ist die eine Seite des ersten thermoelektrischen Generators mit dem ersten Phasenwechselelement und die zweite Seite des ersten thermoelektrischen Generators mit einem Wärmereservoir (Wärmequelle oder Wärmesenke) verbunden. Weiter ist die eine Seite des zweiten thermoelektrischen Generators mit dem zweiten Phasenwechselelement und die zweite Seite des zweiten thermoelektrischen Generators mit dem Wärmereservoir verbunden. Wie oben beschrieben, kann es sich bei diesem Wärmereservoir beispielsweise um eine Außenhaut des Fahrzeugs handeln.

Mit anderen Worten sind eine erste Untereinheit aus dem erstem Phasenwechselelement und dem erstem thermoelektrischen Generator und eine zweite Untereinheit aus dem zweitem Phasenwechselelement und dem zweiten thermoelektrischen Generator bezüglich eines Wärmestroms parallel geschaltet. Der Wärmestrom fließt beispielsweise von der Wärmequelle zum ersten oder zweiten Phasenwechselelement.

Gemäß einem weiteren Aspekt der Erfindung ist das erste Phasenwechselelement als Hohlzylinder ausgeführt, in welchem sich das zweite Phasenwechselelement befindet. Die beiden Phasenwechselelemente können koaxial angeordnet sein und sind beispielsweise durch eine rohrförmige Wärmeisolierung voneinander isoliert.

Gemäß einer weiteren Ausführungsform, nützlich zum Verständnis der Erfindung, ist das erste Phasenwechselelement unter dem zweiten Phasenwechselelement angeordnet. Dazwischen befinden sich einer oder mehrere thermoelektrische Generatoren.

So ist beispielsweise der zweite thermoelektrische Generator zwischen dem ersten Phasenwechselelement und dem zweiten Phasenwechselelement angeordnet und mit den beiden Phasenwechselelementen thermisch gekoppelt, so dass er den Temperaturunterschied zwischen den beiden Phasenwechselelementen zur Energiegewinnung ausnutzen kann.

Auch ist eine Kombination aus nebeneinander, übereinander und ineinander angeordneten Phasenwechselelementen möglich.

Gemäß einer weiteren Ausführungsform der Erfindung ist zwischen den beiden Phasenwechselelementen eine Wärmeisolierung angeordnet, bei der es sich beispielsweise um eine Keramik handeln kann.

Auch können die thermoelektrischen Generatoren und/oder die Phasenwechselelemente in einem gemeinsamen Gehäuse untergebracht sein, welches einerseits mechanischen Schutz bieten kann und andererseits ebenfalls als thermische Isolierung dient. Beispielsweise weist das gemeinsame Gehäuse eine Keramik auf.

Gemäß einer weiteren Ausführungsform der Erfindung weist die Energieversorgungseinheit ein metallisches Element in Form einer Folie, einer

Beschichtung oder einer Platte auf, welches mit einer zweiten Seite des ersten thermoelektrischen Generators verbunden ist und als Kontaktfläche zur thermischen Kontaktierung einer Außenhaut des Fahrzeugs dient.

Dieses metallische Element kann flächig ausgeführt sein und eine Oberflächenform aufweisen, die der Oberflächenform der Außenhaut des Fahrzeugs entspricht, so dass die Befestigung der Energieversorgungseinheit an der Außenhaut erleichtert wird.

Gemäß einem weiteren Aspekt der Erfindung ist ein elektrisches System für ein Fahrzeug angegeben, welches einen Sensor zum Erfassen einer physikalischen Größe in dem Fahrzeug oder in der Umgebung des Fahrzeugs sowie eine oben und im Folgenden beschriebene Energieversorgungseinheit aufweist, die dazu ausgeführt ist, den Sensor autark zu betreiben, also mit Energie zu versorgen.

Insbesondere kann zu diesem Zweck die Energieversorgungseinheit einen oder mehrere Energiespeicher (wie Akkumulatoren oder Kondensatoren) aufweisen, um überschüssige Energie zwischenzuspeichern, welche zu einem späteren Zeitpunkt an den Sensor abgegeben werden kann.

Gemäß einem weiteren Aspekt der Erfindung ist die Verwendung einer oben und im Folgenden beschriebenen Energieversorgungseinheit und eines oben und im Folgenden beschriebenen elektrischen Systems in einem Fahrzeug angegeben.

Insbesondere ist es möglich, dass das metallische Element, welches oben angesprochen wurde, eine strukturelle Komponente des Fahrzeugs ausbildet. Mit anderen Worten kann demnach der thermoelektrische Generator direkt an einem Teil der Außenhaut oder einer tragenden Komponente des Fahrzeugs befestigt sein, so dass keine gesonderte Komponente für das metallische Element notwendig ist. Der thermoelektrische Generator kann also direkt an einer Innenfläche des Fahrzeugs befestigt werden, beispielsweise indem er auf die betreffende Innenfläche des Fahrzeugs aufgeklebt wird.

Gemäß einer Ausführungsform der Erfindung umfasst die Energieversorgungseinheit eine Spannungsregelung, die dazu ausgeführt ist, eine durch die thermoelektrischen Generatoren erzeugte Spannung in eine niedrigere Spannung zu transformieren. Mit der Spannungsregelung kann die durch die thermoelektrischen Generatoren erzeugte Spannung, die mehrere Kilovolt betragen kann, in eine niedrigere Spannung von weniger als 100 Volt umgewandet werden, die von weiteren elektrischen Komponenten, wie einem elektrischen Energiespeicher und/oder dem elektrischen Flugzeugsystem, besser verarbeitet werden kann.

Als Energiespeicher zur Speicherung der von den thermoelektrischen Generatoren erzeugten Energien kann beispielsweise ein Superkondensator vorgesehen sein. Beispielsweise kann der Energiespeicher beim Aufsteigen und/oder Landen des Luftfahrzeugs aufgeladen werden. Die elektrische Energie aus dem Energiespeicher kann dann die gesamte Zeit dem elektrischen System zur Verfügung gestellt werden.

Unter dem oben genannten "autarken Betreiben" des Sensors ist zu verstehen, dass das elektrische System nicht über Leitungen zur Stromversorgung mit einem zentralen Energieversorgungsnetzwerk des Fahrzeugs verbunden sein muss.

Das elektrische System kann auch eine, ggf. drahtlose, Kommunikationseinheit umfassen, um die Sensordaten einfach auslesen zu können.

Ein weiterer Aspekt der Erfindung betrifft ein Luftfahrzeug mit einer oben und im Folgenden beschriebenen Energieversorgungseinheit und/oder einem oben und im Folgenden beschriebenen elektrischen System.

Im Folgenden werden Ausführungsbeispiele der Erfindung mit Bezug auf die beiliegenden Figuren detailliert beschrieben.

### Kurze Beschreibung der Figuren

Fig. 1 zeigt eine schematische Darstellung einer Energieversorgungseinheit mit einem thermoelektrischen Generator.
Fig. 2 zeigt eine schematische Darstellung einer Energieversorgungseinheit nützlich zum Verständnis der Erfindung.
Fig. 3 zeigt eine schematische Darstellung einer Energieversorgungseinheit gemäß einem Ausführungsbeispiel der Erfindung.
Fig. 4 zeigt eine schematische Querschnittsdarstellung einer Energieversorgungseinheit gemäß einem weiteren Ausführungsbeispiel der Erfindung.
Fig. 5 zeigt eine schematische Darstellung einer Energieversorgungseinheit gemäß einem weiteren Ausführungsbeispiel der Erfindung.
Fig. 6 zeigt eine schematische Darstellung einer Energieversorgungseinheit, nützlich zum Verständnis der Erfindung.
Fig. 7 zeigt eine schematische Darstellung einer Energieversorgungseinheit gemäß einem weiteren Ausführungsbeispiel der Erfindung.
Fig. 8 zeigt ein Luftfahrzeug gemäß einem Ausführungsbeispiel der Erfindung.

Werden in der folgenden Figurenbeschreibung die gleichen Bezugszeichen verwendet, so können diese gleiche oder ähnliche Elemente bezeichnen. Gleiche oder ähnliche Elemente können aber auch durch unterschiedliche Bezugszeichen bezeichnet sein.

### Detaillierte Beschreibung von Ausführungsbeispielen

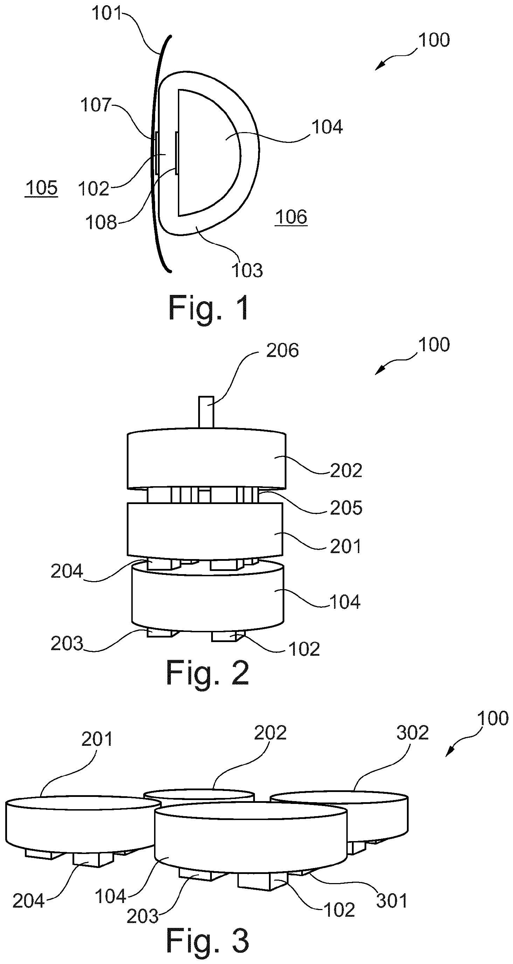

Fig. 1 zeigt eine Energieversorgungseinheit 100, die einen thermoelektrischen Generator 102 aufweist und innerhalb eines Rumpfes angeordnet ist. Das Bezugszeichen 101 bezeichnet die Außenhaut des Rumpfes, wobei die linke Seite 105 der Außenhaut zur Umgebung des Fahrzeugs weist und die rechte Seite 106 zum Inneren des Fahrzeugs, auf welcher die Energieversorgungseinheit 100 angeordnet ist.

Auf der einen Seite 108 des thermoelektrischen Generators 102 befindet sich ein Phasenwechselelement 104 und auf der anderen Seite 107 des thermoelektrischen Generators 102 befindet sich die Außenhaut 101.

Das Phasenwechselelement 104 und große Teile des thermoelektrischen Generators 102 können von einer Isolationshülle 103 umgeben sein. Allerdings ist die zweite Seite 107 des thermoelektrischen Generators nicht von der Isolationshülle 103 umgeben, da diese zweite Seite 107 thermischen Kontakt zur Außenhaut 101 bilden soll. Die Energieversorgungseinheit kann an der Seite 107 auf die Außenhaut 101 aufgeklebt oder anderweitig daran befestigt werden.

Eine grundsätzliche Idee der Energiegewinnung gemäß der vorliegenden Erfindung besteht darin, dass ein Phasenwechselelement 104 mit einem Phasenwechselmaterial verwendet wird. Der thermoelektrische Generator (TEG) 102 ist auf der linken Seite 107 mit einer Wärmequelle oder -senke (typischerweise die Außenhaut des Fahrzeugs) verbunden. Seine zweite Seite 108 hingegen ist mit der Wärmekapazität 104 verbunden. Das Phasenwechselelement wird dazu verwendet, die thermische Kapazität des Wärmereservoirs auf der ersten Seite 108 des thermoelektrischen Generators zu erhöhen, um auf diese Weise einen zusätzlichen Temperaturgradienten zu erzeugen. Wenn die Temperatur des Phasenwechselelements dessen Schmelz- oder Gefrierpunkt erreicht, kann die latente Wärme dazu verwendet werden, den Temperaturgradienten weiter zu erhöhen und somit die Erzeugung elektrischer Energie noch effizienter zu gestalten.

Möchte man die Ausbeute (Effizienz) der Energieversorgungseinheit noch weiter erhöhen, können verschiedene Modifikationen, wie sie in den Figuren 2 bis 7 gezeigt sind, erfolgen.

Fig. 2 zeigt eine Energieversorgungseinheit 100, bei der mehrere (beispielsweise drei) Phasenwechselelemente 104, 201, 202 übereinander angeordnet sind. Dazwischen befinden sich jeweils eins, zwei, drei, vier oder mehr thermoelektrische Generatoren 204, 205. Unter dem unteren Phasenwechselelement 104 befinden sich ebenfalls wieder eins, zwei, drei, vier oder mehr thermoelektrische Generatoren 102, 203.

Die erzeugte elektrische Energie kann dann über die Leitung 206 abgeführt werden, beispielsweise zu einem Zwischenspeicher in Form eines Superkondensators oder anderweitigen Akkumulators oder zu einer Regeleinheit oder direkt zum elektrischen Verbraucher.

Es sind also mehrere Schichten vorgesehen und in jeder Schicht befinden sich ein oder mehrere thermoelektrische Generatoren sowie ein oder mehrere Phasenwechselelemente oder anderweitige Wärmekapazitäten. Durch diese Verschaltung kann das effektiv nutzbare Temperaturintervall zur Energiegewinnung vergrößert werden, insbesondere wenn verschiedene Phasenwechselelemente mit verschiedenen Phasenwechselpunkten (also beispielsweise verschiedenen Schmelz- oder Gefrierpunkten) verwendet werden. Gemäß Fig. 2 sind die verschiedenen Schichten übereinander angeordnet.

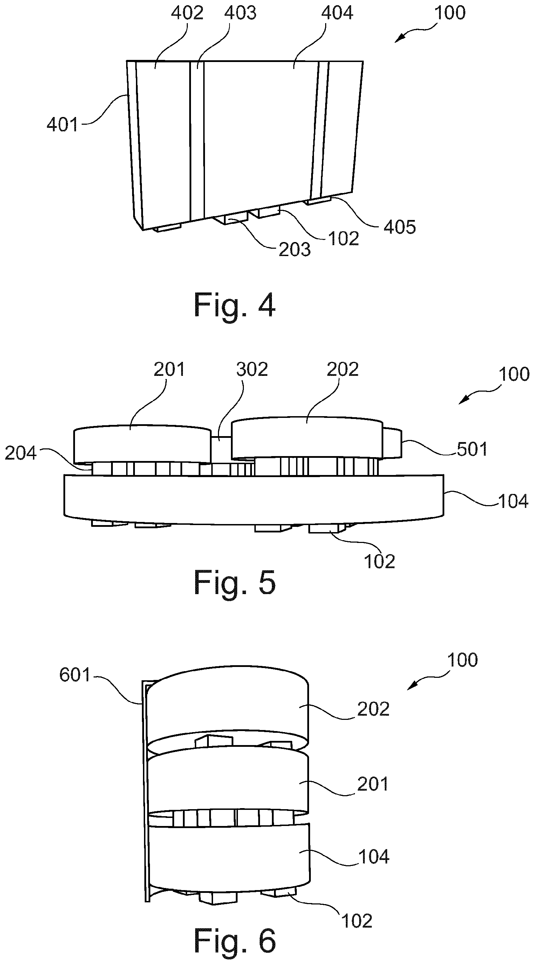

Die verschiedenen Schichten sind gemäß der Erfindung, wie in Fig. 3 und 4 zu sehen, nebeneinander angeordnet. Vorteilhaft ist es, wenn die Wärmekapazität und die latente Wärme (Heat of Fusion) der Phasenwechselelemente hoch sind. Auch ist es vorteilhaft, wenn die unterschiedlichen Phasenwechselelemente eine hohe thermische Leitfähigkeit aufweisen.

In der Fig. 3 ist zu sehen, dass mehrere Phasenwechselelemente 104, 201, 202, 302 nebeneinander angeordnet sind. Unter den vier Phasenwechselelementen befinden sich jeweils wieder mehrere thermoelektrische Generatoren 102, 203, 204, beispielsweise jeweils vier. Die thermoelektrischen Generatoren 102, 203, 204 und 301 können beispielsweise an ein Wärmereservoir angeschlossen werden. In diesem Fall ist das Phasenwechselelement 201 mit dem thermoelektrischen Generator 204 verbunden und der thermoelektrische Generator 204 ist wiederum mit dem Wärmereservoir verbunden. Das Phasenwechselelement 104 ist mit den thermoelektrischen Generatoren 102, 203 sowie 301 verbunden und die thermoelektrischen Generatoren 102, 203 sowie 203 sind wiederum mit dem Wärmereservoir verbunden. Es können auch mehr oder weniger thermoelektrische Generatoren pro Phasenwechselelement vorgesehen sein. So kann zum Beispiel jedes Phasenwechselelement 104, 201, 202 und 302 jeweils über einen thermoelektrischen Generator mit dem Wärmereservoir verbunden sein. Beispielsweise handelt es sich beim Wärmereservoir um eine Außenhaut des Fahrzeugs.

Bei den Ausführungsbeispielen der Figuren 3 und 4 wird das effektiv nutzbare Temperaturintervall vergrößert, indem die Phasenwechselelemente nebeneinander angeordnet werden. In der Fig. 3 weisen die vier Phasenwechselelemente einen verhältnismäßig großen Abstand zueinander auf, wohingegen im Ausführungsbeispiel der Fig. 4 zwei Phasenwechselelemente koaxial zueinander angeordnet sind. Hierbei ist das erste Phasenwechselelement 404 zylinderförmig ausgeführt und das zweite Phasenwechselelement 402 hohlzylinderförmig darum gelegt. Auf diese Weise kann das Gesamtvolumen der Energieerzeugungseinheit verringert werden.

Zwischen den beiden Phasenwechselelementen 402, 404 befindet sich eine ebenfalls hohlzylinderförmige Isolationsschicht 403, beispielsweise aus einer Keramik. Beide Phasenwechselelemente 402, 404 sind von einer äußeren Isolationshülle 401 umgeben, welche ebenfalls keramisch sein kann.

Jedes der beiden Phasenwechselelemente 402, 404 ist an einen oder mehrere thermoelektrische Generatoren 102, 203, 405 angeschlossen.

Zur Vermeidung bzw. zur Verringerung eines Wärmeflusses zwischen den beiden Phasenwechselelementen 402, 404 ist die thermische Isolierung 403 vorgesehen. Hierdurch kann die Effizienz der Energieversorgungseinheit weiter erhöht werden.

An dieser Stelle sei angemerkt, dass die in den Figuren 2, 3, 5, 6 und 7 gezeigten Einheiten 104, 201, 202, 302, 501 ebenfalls koaxial, wie in der Fig. 4 gezeigt, aufgebaut sein können, also mehrere, ineinander verschachtelte Phasenwechselelemente aufweisen können. Insbesondere ist zu beachten, dass das Ausführungsbeispiel der Fig. 4 noch durch einen oder mehrere weitere hohlzylinderartige Phasenwechselelemente ergänzt werden kann, welche um den Hohlzylinder 402 herum angeordnet sind. Zwischen den Phasenwechselelementen befindet sich jeweils eine Isolationsschicht.

Fig. 5 zeigt ein weiteres Ausführungsbeispiel einer Energieversorgungseinheit 100, bei dem die Phasenwechselelemente 104, 201, 202, 302, 501 teilweise nebeneinander und teilweise übereinander angeordnet sind. Es ist ein verhältnismäßig großes Phasenwechselelement 104 in einer unteren Ebene vorgesehen, über dem sich vier nebeneinander angeordnete Phasenwechselelemente 201, 202, 302, 501 befinden.

Zwischen den übereinander angeordneten Phasenwechselelementen befinden sich thermoelektrische Generatoren. Auch sind thermoelektrische Generatoren 102 an der Unterseite des unteren Phasenwechselelements 104 vorgesehen.

Auf der oberen Ebene befinden sich demnach mehrere Phasenwechselelemente, deren Phasenwechselmaterialien verschiedene Phasenwechselpunkte (Schmelz- oder Gefrierpunkte) aufweisen. Die untere Schicht 104 weist eine hohe thermische Leitfähigkeit auf, so dass ein effektiver Wärmetransport von der Außenhaut durch die untere Schicht 104 hindurch hin zu den Phasenwechselelementen 201, 202, 302, 501 und der oberen Schicht sichergestellt ist. Hierdurch kann die Effektivität der Energieversorgungseinheit weiter erhöht werden, so dass drahtlose Sensoren sicher betrieben werden können.

Fig. 6 zeigt ein weiteres Ausführungsbeispiel einer Energieversorgungseinheit 100, nützlich zum Verständnis der Erfindung, bei der drei Phasenwechselelemente 104, 201, 202 übereinander angeordnet sind, ähnlich wie das in der Fig. 2 gezeigt ist. Der gesamte Stapel 104, 201, 202 ist in einer thermischen Isolierung angeordnet, welche beispielsweise in Form einer keramischen Umhausung 601 ausgeführt sein kann, die mit Ausnahme der Unterseiten der unteren thermoelektrischen Generatoren 102 die gesamte Energieversorgungseinheit umgeben kann. Auf diese Weise kann sichergestellt werden, dass der Wärmefluss hauptsächlich von der Unterseite, an welcher die Einheit mit der Außenhaut verbunden ist, zur Oberseite stattfindet. Auch kann auf diese Weise der Einbau der Energieversorgungseinheit erleichtert werden.

Es kann auch vorgesehen sein, dass die thermisch isolierende Umhausung 601 in Form eines oben geschlossenen und unten vollständig offenen Rohrs ausgeführt ist, so dass der Stapel 104, 201, 202 von unten in die Umhausung 601 eingeschoben werden kann.

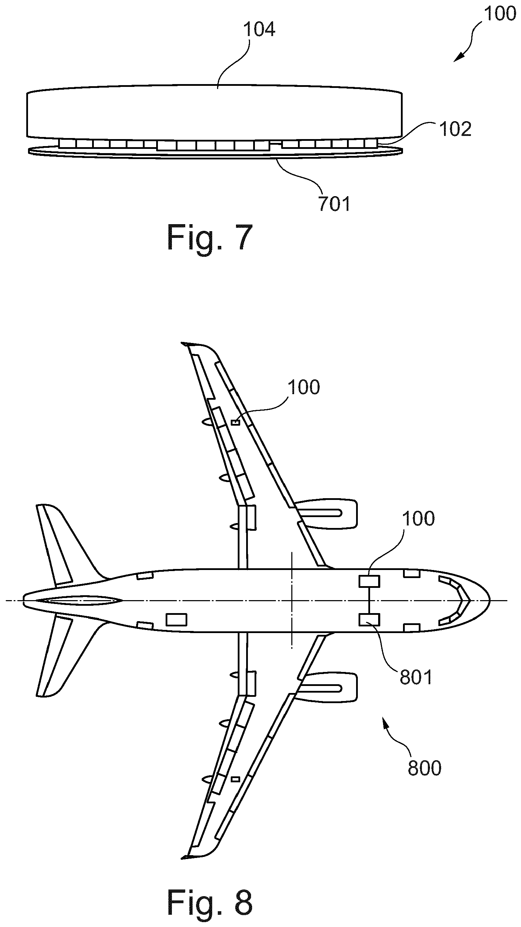

Fig. 7 zeigt ein weiteres Ausführungsbeispiel der Energieversorgungseinheit 100, bei dem die Unterseite der thermoelektrischen Generatoren 102 mit einem dünnen metallischen Element 701 verbunden ist. Hierbei kann es sich beispielsweise um eine Metallplatte, eine Beschichtung oder eine dünne Metallfolie handeln, die beispielsweise aus Aluminium besteht. Auf diese Weise kann die Installation der Energieversorgungseinheit weiter erleichtert werden. Zwar erhöht das Metallelement 701 den thermischen Widerstand der Energieversorgungseinheit, jedoch kann durch das Vorsehen eines solchen Metallelements 701 der Installationsaufwand reduziert werden, beispielsweise indem das Metallelement 701 auf der Außenhaut aufgeklebt oder aufgelötet wird.

Fig. 8 zeigt ein Luftfahrzeug 800 mit einer Energieversorgungseinheit 100, welche einen Sensor 801 mit Energie versorgt. Diese Energieversorgungseinheit 100 befindet sich im Rumpf. Auch können die Energieversorgungseinheiten an anderen Stellen angeordnet sein, beispielsweise im Flügel. Anstelle eines Sensors 801 kann auch ein anderer elektrischer Verbraucher mit Energie versorgt werden. Die Energieversorgungseinheit 100 ist beispielsweise in einem Innenraum des Luftfahrzeugs angebracht und an einer Seite mit der Außenhaut des Luftfahrzeugs verbunden.

Ergänzend sei darauf hingewiesen, dass "umfassend" und "aufweisend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkungen anzusehen.

## Patentansprüche

1. Energieversorgungseinheit (100) für einen elektrischen Verbraucher (801) eines Fahrzeugs (800), die Energieversorgungseinheit (100) aufweisend:
einen ersten thermoelektrischen Generator (102) und einen zweiten thermoelektrischen Generator (204);
ein erstes Phasenwechselelement (104), das mit einer Seite des ersten thermoelektrischen Generators (102) verbunden ist;
ein zweites Phasenwechselelement (201), das mit einer Seite des zweiten thermoelektrischen Generators (204) verbunden ist;
wobei das erste Phasenwechselelement (104) einen anderen Schmelzpunkt aufweist als das zweite Phasenwechselelement (201);
wobei das erste Phasenwechselelement (104) neben dem zweiten Phasenwechselelement (201) angeordnet ist und das erste Phasenwechselelement (104) und das zweite Phasenwechselelement (201) bezüglich eines Wärmestroms parallel geschaltet sind.

2. Energieversorgungseinheit (100) nach Anspruch 1,
wobei das erste Phasenwechselelement (104, 402) als Hohlzylinder ausgeführt ist, in welchem das zweite Phasenwechselelement (201, 404) angeordnet ist.

3. Energieversorgungseinheit (100) nach einem der vorhergehenden Ansprüche, weiterhin aufweisend:
eine Wärmeisolierung (403), die zwischen den beiden Phasenwechselelementen (104, 402, 201, 404) angeordnet ist.

4. Energieversorgungseinheit (100) nach einem der vorhergehenden Ansprüche, weiterhin aufweisend:
ein gemeinsames Gehäuse (601), in welchem die thermoelektrischen Generatoren (102, 204) und die Phasenwechselelemente (104, 201) untergebracht sind.

5. Energieversorgungseinheit (100) nach Anspruch 4,
wobei das gemeinsame Gehäuse (601) eine Keramik aufweist.

6. Energieversorgungseinheit (100) nach einem der vorhergehenden Ansprüche, weiterhin aufweisend:
ein metallisches Element (701) in Form einer Folie, einer Beschichtung oder einer Platte, welches mit einer zweiten Seite des ersten thermoelektrischen Generators (102) verbunden ist und als Kontaktfläche zur thermischen Kontaktierung einer Außenhaut (101) des Fahrzeugs (800) dient.

7. Elektrisches System (100, 801) für ein Fahrzeug (800), das elektrische System umfassend:
einen Sensor (801) zum Erfassen einer physikalischen Größe in dem Fahrzeug (800) oder der Umgebung des Fahrzeugs (800);
eine Energieversorgungseinheit (100) nach einem der vorhergehenden Ansprüche, die dazu ausgeführt ist, den Sensor (801) autark zu betreiben.

8. Verwendung einer Energieversorgungseinheit (100) nach einem der Ansprüche 1 bis 6 in einem Fahrzeug (800).

9. Luftfahrzeug (800) mit einer Energieversorgungseinheit (100) nach einem der Ansprüche 1 bis 6 oder einem elektrischen System nach Anspruch 7.

## Claims

1. An energy supply unit (100) for an electrical load (801) of a vehicle (800), the energy supply unit (100) comprising:
a first thermoelectric generator (102) and a second thermoelectric generator (204);
a first phase change element (104) connected with a side of the first thermoelectric generator (102);
a second phase change element (201) connected with a side of the second thermoelectric generator (204);
wherein the first phase change element (104) has a melting point different from the one of the second phase change element (201);
wherein the first phase change element (104) is arranged alongside the second phase change element (104), and the first phase change element (104) and the second phase change element are connected in parallel in respect of a heat flow.

2. The energy supply unit (100) according to claim 1,
wherein the first phase change element (104, 402) is designed as a hollow cylinder in which the second phase change element (201, 404) is arranged.

3. The energy supply unit (100) according to one of the preceding claims, further comprising:
a heat insulation (403) arranged between the two phase change elements (104, 402, 201, 404).

4. The energy supply unit (100) according to one of the preceding claims, further comprising:
a common housing (601) in which the thermoelectric generators (102, 204) and the phase change elements (104, 201) are arranged.

5. The energy supply unit (100) according to claim 4,
wherein the common housing (601) comprises ceramics.

6. The energy supply unit (100) according to one of the preceding claims, further comprising:
a metallic element formed as a foil, a coating, or a plate, which is connected with a second side of the first thermoelectric generator (102) and which serves as a contact surface for thermal contact with an outer skin of the vehicle (800).

7. An electrical system (100, 801) for a vehicle (800), the electrical system comprising:
a sensor (801) for detecting a physical entity in the vehicle (800) or in the environment of the vehicle (800);
an energy supply unit (100) according to one of the preceding claims which is designed to operate the sensor (801) in a self-sufficient manner.

8. Use of an energy supply unit (100) according to one of claims 1 to 6 in a vehicle (800).

9. An aircraft (800) comprising an energy supply unit (100) according to one of claims 1 to 6 or an electrical system according to claim 7.

## Revendications

1. Unité d'alimentation en énergie (100) pour un consommateur électrique (801) d'un véhicule (800), l'unité d'alimentation en énergie (100) présentant :
un premier générateur (102) thermoélectrique et un deuxième générateur (204) thermoélectrique ;
un premier élément de changement de phase (104) qui est relié à un côté du premier générateur (102) thermoélectrique ;
un deuxième élément de changement de phase (201) qui est relié à un côté du deuxième générateur (204) thermoélectrique ;
dans laquelle le premier élément de changement de phase (104) présente un autre point de fusion que le deuxième élément de changement de phase (201) ;
dans laquelle le premier élément de changement de phase (104) est disposé à côté du deuxième élément de changement de phase (201), et dans laquelle le premier élément de changement de phase (104) et le deuxième élément de changement de phase (201) sont connectés en parallèle par rapport à un courant thermique.

2. Unité d'alimentation en énergie (100) selon la revendication 1,
dans laquelle le premier élément de changement de phase (104, 402) est réalisé comme cylindre creux, dans lequel est disposé le deuxième élément de changement de phase (201, 404).

3. Unité d'alimentation en énergie (100) selon l'une quelconque des revendications précédentes, présentant en outre :
une isolation thermique (403) qui est disposée entre les deux éléments de changement de phase (104, 402, 201, 404).

4. Unité d'alimentation en énergie (100) selon l'une quelconque des revendications précédentes, présentant en outre :
un boîtier commun (601) dans lequel sont logés les générateurs (102, 204) thermoélectriques et les éléments de changement de phase (104, 201).

5. Unité d'alimentation en énergie (100) selon la revendication 4,
dans laquelle le boîtier commun (601) présente une céramique.

6. Unité d'alimentation en énergie (100) selon l'une quelconque des revendications précédentes, présentant en outre :
un élément métallique (701) sous forme d'un film, d'un revêtement ou d'une plaque, lequel est relié à un deuxième côté du premier générateur (102) thermoélectrique et sert de surface de contact pour la mise en contact thermique d'une peau extérieure (101) du véhicule (800).

7. Système électrique (100, 801) pour un véhicule (800), le système électrique comprenant :
un capteur (801) destiné à détecter une grandeur physique dans le véhicule (800) ou dans les environs du véhicule (800) ;
une unité d'alimentation en énergie (100) selon l'une quelconque des revendications précédentes, laquelle est réalisée pour faire fonctionner le capteur (801) de manière autonome.

8. Utilisation d'une unité d'alimentation en énergie (100) selon l'une quelconque des revendications 1 à 6 dans un véhicule (800).

9. Aéronef (800) comportant une unité d'alimentation en énergie (100) selon l'une quelconque des revendications 1 à 6 ou comportant un système électrique selon la revendication 7.
